# EUROPEAN PATENT APPLICATION

(11) **EP 4 661 619 A1**
(43) Date of publication of application: **10.12.2025**
(21) Application number: 25181199.8
(22) Date of filing: 05.06.2025
(51) Int. Cl.: H10D 62/10, H10D 64/27, H10D 62/17, H10D 30/01, H10D 30/00, H10D 30/67

(54) **SUBFIN ENGINEERING TO IMPROVE SEMICONDUCTOR DEVICE PERFORMANCE**

(30) Priority: 07.06.2024 US 202418736673
(71) Applicant: Intel Corporation, Santa Clara, CA 95054 (US)
(72) Inventor: ZHU, Baofu, Portland, 97229 (US); TIWARI, Vishal, Hillsboro, 97123 (US); LAVRIC, Dan S., Portland, 97229 (US); CHAO, Yu-Lin, Portland, 97209 (US); JAIN, Ankit, Portland, 97209 (US)
(74) Representative: 2SPL Patentanwälte PartG mbB

(57) **Abstract**

Techniques are provided herein to form semiconductor devices with gate structures that do not extend below a top surface of dielectric subregions. A semiconductor device includes a gate structure around or otherwise on a semiconductor region. A lower end of the fin of semiconductor material includes a subfin adjacent to a dielectric fill. A sacrificial material layer is deposited before the formation of the gate structure to prevent the gate structure from forming along the sides of the subfin. This sacrificial layer may then be removed from the backside of the structure along with the semiconductor material of the subfin. The subfin area may be replaced with one or more dielectric materials formed on the backside. As a result, the device performance is improved by lowering the parasitic capacitance caused by having the gate structure on either side of the dielectric structure replacing the subfin region.

## Description

### BACKGROUND

As integrated circuits continue to scale downward in size, a number of challenges arise. For instance, reducing the size of memory and logic cells is becoming increasingly more difficult, as is reducing device spacing at the device layer. As transistors are packed more densely, parasitic effects can increasingly impact the device operation in an undesirable way. Accordingly, there remain a number of non-trivial challenges with respect to forming semiconductor devices.

### BRIEF DESCRIPTION OF THE DRAWINGS

Figures 1A and 1B are cross-sectional and plan views, respectively, of some semiconductor devices with gate structures that do not extend below a top surface of dielectric subregions, in accordance with an embodiment of the present disclosure.
Figures 2A - 2O' are cross-sectional views that illustrate various stages in an example process for forming semiconductor devices with gate structures that do not extend below a top surface of dielectric subregions, in accordance with some embodiments of the present disclosure.
Figure 3 illustrates a cross-sectional view of a chip package containing one or more semiconductor dies, in accordance with some embodiments of the present disclosure.
Figure 4 is a flowchart of a fabrication process for semiconductor devices with gate structures that do not extend below a top surface of dielectric subregions, in accordance with an embodiment of the present disclosure.
Figure 5 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form semiconductor devices with gate structures that do not extend below a top surface of dielectric subregions. The techniques can be used in any number of integrated circuit applications and are particularly useful with respect to non-planar transistors that have a subfin portion, such as finFETs or gate-all-around transistors (e.g., ribbonFETs and nanowire FETs). In an example, a semiconductor device includes a gate structure around or otherwise on a semiconductor region. The semiconductor region can be, for example, a fin of semiconductor material that extends from a source region to a drain region, or one or more nanowires or nanoribbons or nanosheets of semiconductor material that extend from a source region to a drain region. A lower end of the fin of semiconductor material includes a subfin adjacent to a dielectric fill that acts as shallow trench isolation (STI) between semiconductor devices. In conventional devices, portions of the gate structure extend along sides of the subfin near the top surface of the subfin. However, in an example of this disclosure, a sacrificial material layer is deposited before the formation of the gate structure to prevent the gate structure from forming along the sides of the subfin. This sacrificial layer may then be removed from the backside of the structure along with the semiconductor material of the subfin. As a result, the device performance is improved by lowering the parasitic capacitance caused by the gate structure on either side of the dielectric subregion (e.g., the dielectric structure replacing the subfin region). Numerous variations and embodiments will be apparent in light of this disclosure.

### General Overview

As previously noted above, there remain a number of non-trivial challenges with respect to integrated circuit fabrication. In more detail, as devices become smaller and more densely packed, semiconductor subfins beneath semiconductor regions of the devices can form parasitic junctions between source or drain regions, as at least a portion of the source or drain regions may abut the subfins. Furthermore, the subfins can accumulate charge and form parasitic capacitors with adjacent gate structures, such as gate structures that extend along sides of a portion of the subfins. Even if some portion of subfin is removed, the presence of any remaining portion of the subfins, or of any dielectric materials used to replace the subfins, may also cause the gate structures to wrap partially around the top or otherwise remaining portions of the subfins during gate formation. This leads to conductive structures on both sides of the subfin that do not positively contribute to the transistor current while increasing the parasitic capacitance in the device. In operation, these parasitic effects can reduce the switching speed of the transistors and degrade the overall performance.

Thus, techniques are provided herein to prevent the gate structures from forming around the sides of the subfins, and subsequently removing the semiconductor material of the subfins from the backside of the structure. According to some embodiments, a sacrificial material layer (e.g., titanium nitride or aluminum oxide) is formed along the bottom of a gate trench before the formation of the gate structure. The sacrificial material layer may be formed adjacent to one or more subfins that extend into the gate trench, such that a top surface of the sacrificial material layer is substantially coplanar (e.g., within 2 nm) of a top surface of the one or more subfins. The gate structure may then be formed in the gate trench over the sacrificial layer. The sacrificial layer prevents the gate structure from extending below the topmost surface of the one or more subfins.

In some embodiments, the subfins may include a semiconductor material, such as silicon (Si) and/or germanium (Ge), that is a part of or formed on the semiconductor substrate. A bulk portion of the semiconductor substrate may be removed from the backside of the structure to expose the subfins from the bottom. Once exposed, an etch process may be performed to selectively remove the semiconductor material of the subfins, thus forming backside cavities in place of the subfins. The backside cavities may be filled with one or more dielectric materials to form backside subregions. For example, the cavities may be filled or partially filled with a dielectric liner and a dielectric fill. The dielectric liner may include any number of deposited dielectric layers that can include silicon nitride, silicon dioxide, silicon carbide, silicon oxycarbide, silicon oxynitride, silicon oxycarbonitride, or aluminum oxide, to name a few examples. In some embodiments, the dielectric fill can also include any of silicon nitride, silicon dioxide, silicon carbide, silicon oxycarbide, silicon oxynitride, silicon oxycarbonitride, or aluminum oxide, to name a few examples. Additionally, the sacrificial layer may be exposed from the backside and removed using a suitable isotropic etching process.

According to an embodiment, an integrated circuit includes a semiconductor region extending from a source or drain region in a first direction, a gate structure extending over the semiconductor region in a second direction different from the first direction, and a subregion beneath the semiconductor region. The subregion includes a dielectric liner along edges of the subregion and a dielectric fill within at least a portion of a remaining volume of the subregion. No portion of the gate structure extends below a topmost surface of the subregion and at least a portion of the gate structure contacts the topmost surface of the subregion.

According to another embodiment, an integrated circuit includes a semiconductor region extending in a first direction, a gate structure extending over the semiconductor region in a second direction different from the first direction, a dielectric layer beneath the gate structure, and a dielectric subregion beneath the semiconductor region and adjacent to the dielectric layer. A top surface of the dielectric subregion is substantially coplanar with a top surface of the dielectric layer.

According to another embodiment, a method of forming an integrated circuit includes forming a multilayer fin extending in a first direction over a substrate having a device section with first material layers alternating with second material layers, and a subfin beneath the device section; forming a dielectric layer adjacent to the subfin; forming a sacrificial layer on a top surface of the dielectric layer adjacent to a top portion of the subfin; forming a gate structure on the sacrificial layer and extending in a second direction over the first material layers after removing the second material layers of the multilayer fin; removing a portion of the substrate from the backside to expose a bottom surface of the subfin and a bottom surface of the dielectric layer; removing the subfin from the backside to form a backside cavity; forming a dielectric liner within the backside cavity; removing the dielectric layer from the backside to expose a bottom surface of the sacrificial layer; removing the sacrificial layer from the backside; and forming one or more dielectric materials within the backside cavity and adjacent to the backside cavity.

The techniques can be used with any type of non-planar transistors, including finFETs (sometimes called tri-gate transistors), nanowire and nanoribbon transistors (sometimes called gate-all-around transistors), or forksheet transistors, to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the absence of semiconductor subfins (e.g., replaced with dielectric material to form dielectric subregions) and may show that the gate structures do not extend below the top surface of the dielectric subregions. The dielectric subregions may include one or more dielectric layers including a dielectric liner along the sides of the recesses where the subfins used to be.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer. A layer may partially or completely fill a given recess or space or volume. A space or volume that is at least partially within a given layer and devoid of any solid fill materials may be referred to herein as an airgap or a void (used interchangeably herein). Such an airgap or void may be filled with one or more gasses (e.g., oxygen, nitrogen, air, to name a few examples), or be devoid of any gases.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

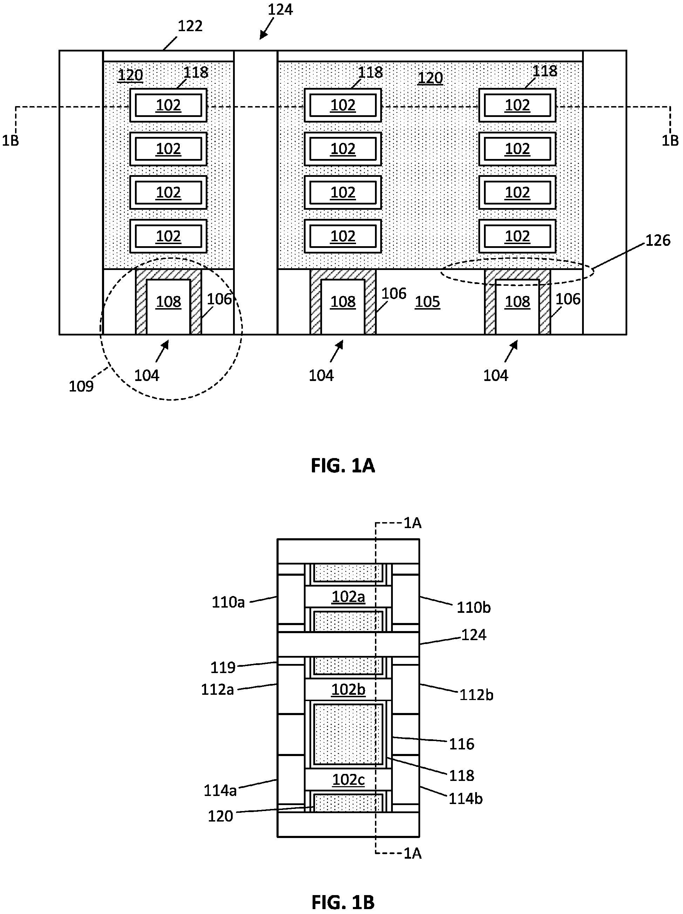

Figure 1A is a cross-sectional view taken across three example semiconductor devices, according to an embodiment of the present disclosure. Figure 1B is a plan view of the adjacent semiconductor devices taken across the dashed line 1B-1B depicted in Figure 1A, and Figure 1A illustrates the cross-section taken across the dashed line 1A-1A depicted in Figure 1B. It should be noted that some of the material layers (such as gate cap 122) are not visible in the top-down view of Figure 1B, given the location of the depicted cross-section. Each of the semiconductor devices may be non-planar metal oxide semiconductor (MOS) transistors, such as tri-gate (e.g., finFET) or gate-all-around (GAA) transistors, although other transistor topologies and types could also benefit from the techniques and structures provided herein. The illustrated example embodiments herein use the GAA structure. The illustrated semiconductor devices represent a portion of an integrated circuit that may contain any number of similar semiconductor devices.

Each of the semiconductor devices includes one or more nanoribbons 102 that extend parallel to one another along a direction between a source region and a drain region (e.g., a first direction into and out of the page in the cross-section view of Figure 1A). Nanoribbons 102 are one example of semiconductor regions or semiconductor bodies that extend between source and drain regions. The term nanoribbon may also encompass other similar shapes such as nanowires or nanosheets. The semiconductor material of nanoribbons 102 may be formed from a substrate. In the illustrated example, the substrate has been removed from the backside and replaced with dielectric subregions 104. According to some embodiments, subregions 104 encompass at least the regions that were occupied by the semiconductor subfins that were removed during a backside process. Subregions 104 may include a dielectric liner 106 and a dielectric fill 108, according to some embodiments. Dielectric liner 106 may extend along the edges of subregion 104 and include a top portion that directly abuts a bottom surface of a gate electrode 120. Dielectric liner 106 may include silicon and any one or more of nitrogen, carbon, or oxygen. Dielectric fill 108 may similarly include silicon and any one or more of nitrogen, carbon, or oxygen. According to some embodiments, a dielectric layer 105 extends between adjacent dielectric subregions 104 beneath the gate structure. In some examples, a bottom surface of dielectric layer 105 is substantially coplanar with a bottom surface of dielectric subregions 104. Dielectric layer 105 may be any suitable dielectric material, such as silicon dioxide. In some examples, dielectric liner 106 and dielectric fill 108 are a first dielectric material(s), and dielectric layer 105 is a second dielectric material that is etch selective to the material(s) of liner 106 and fill 108. In this manner, dielectric liner 106 and dielectric fill 108 can be selectively removed during a backside process and replaced with one or more layers of conductive material to provide a backside gate contact, as generally indicated at 109. Such backside contacts can then be routed by one or more backside interconnect layers. In some such examples, the far left gate electrode 120 may be backside contacted, and dielectric liner 106 and dielectric fill 108 may remain under the right most gate electrodes 120. Other examples may be configured differently, to provide selective backside gate contacts.

In some embodiments, the semiconductor devices may each include semiconductor regions in the shape of fins that can be, for example, native to the substrate (formed from the substrate itself), such as silicon fins etched from a bulk silicon substrate. Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of the illustrated nanoribbons 102 during a gate forming process where one type of the alternating layers is selectively etched away so as to liberate the other type of alternating layers within the channel region, so that a gate-all-around (GAA) process can then be carried out. Again, the alternating layers can be blanket deposited and then etched into fins or deposited into fin-shaped trenches, according to some examples.

According to some embodiments, nanoribbons 102 (or other semiconductor bodies) extend between a source and a drain region in the first direction to provide an active region for a transistor (e.g., the semiconductor region beneath the gate). The source and drain regions are not shown in the cross-section of Figure 1A, but are seen in the top-down view of Figure 1B where nanoribbons 102a of a first semiconductor device extend between a source region 110a and a drain region 110b, nanoribbons 102b of a second semiconductor device extend between a source region 112a and a drain region 112b, and nanoribbons 102c of a third semiconductor device extend between a source region 114a and a drain region 114b. Any source region may also act as a drain region and *vice versa* depending on the circuit configuration. Figure 1B also illustrates spacer structures 116 that extend around the ends of nanoribbons 102 and along sidewalls of the gate structures between spacer structures 116. Spacer structures 116 may include a dielectric material, such as silicon nitride. A dielectric fill 119 may be present adjacent to source or drain regions along the source/drain trenches. Dielectric fill 119 may be any suitable dielectric material, such as silicon dioxide, silicon nitride, or silicon oxynitride.

According to some embodiments, the source and drain regions are epitaxial regions that are provided using an etch-and-replace process. In other embodiments one or both of the source and drain regions could be, for example, implantation-doped native portions of the semiconductor fins or substrate. Any semiconductor materials suitable for source and drain regions can be used (e.g., group IV and group III-V semiconductor materials). The source and drain regions may include multiple layers such as liners and capping layers to improve contact resistance. In any such cases, the composition and doping of the source and drain regions may be the same or different, depending on the polarity of the transistors. In an example, one or more transistors may be p-channel MOS (PMOS) transistors, and one or more transistors may be n-channel MOS (NMOS) transistors. Any number of source and drain configurations and materials can be used.

According to some embodiments, a gate structure extends over nanoribbons 102 of the semiconductor devices along a second direction across the page of Figure 1A. The second direction may be orthogonal to the first direction. The gate structure includes a gate dielectric 118 and a gate layer (or gate electrode) 120. Gate dielectric 118 represents any number of dielectric layers present between nanoribbons 102 and gate electrode 120. Gate dielectric 118 may also be present on the surfaces of other structures within the gate trench. Gate dielectric 118 may include any suitable gate dielectric material(s). In some embodiments, gate dielectric 118 includes a layer of native oxide material (e.g., silicon dioxide) on the nanoribbons or other semiconductor regions making up the channel region of the devices, and a layer of high-K dielectric material (e.g., hafnium oxide) on the native oxide.

Gate electrode 120 may represent any number of conductive layers, such as any metal, metal alloy, or doped polysilicon layers. In some embodiments, gate electrode 120 includes one or more workfunction metals around nanoribbons 102. In some embodiments, the semiconductor devices are p-channel devices that include a workfunction metal having titanium around nanoribbons 102. In some embodiments, the semiconductor devices are an n-channel devices that include a workfunction metal having tungsten around nanoribbons 102. Gate electrode 120 may also include a fill metal or other conductive material (e.g., tungsten, ruthenium, molybdenum, copper, aluminum) around the workfunction metals to provide the whole gate electrode structure. In some embodiments, a gate cap 122 may be formed over gate electrode 120 to protect the underlying material during processing. Gate cap 122 may be any suitable dielectric material, such as silicon nitride.

In some embodiments, adjacent gate structures may be separated along the second direction (e.g., across the page) by a gate cut 124, which acts like a dielectric barrier or wall. Gate cut 124 extends vertically (e.g., in a third direction) through at least an entire thickness of the gate structure and along at least a portion of an entire thickness of subregion 104. According to some embodiments, gate cut 124 is formed from any number of dielectric materials. For example, gate cut 124 may include a dielectric liner and a dielectric fill on the dielectric liner. According to some embodiments, the dielectric liner includes a high-k dielectric material, such as silicon nitride or aluminum oxide, and the dielectric fill includes a low-k dielectric material, such as silicon dioxide, porous silicon dioxide, or flowable oxide.

Gate cut 124 extends in the first direction as seen in Figure 1B such that it cuts across at least the entire width of the gate trench. According to some embodiments, gate cut 124 may also extend further past spacer structures 116 and between adjacent source or drain regions. In some examples, gate cut 124 extends across more than one gate trench in the first direction (e.g., cutting through more than one gate structure running parallel along the second direction).

Due to the fabrication process described in more detail herein, a bottom surface of the gate trench has a topology 126 over subregion 104. For example, a top surface of dielectric liner 106 contacts the gate structure, yet no part of the gate structure extends below the top surface of dielectric liner 106. In some embodiments, the top surface of dielectric liner 106 (or top surface of dielectric subregion 104) is substantially coplanar (e.g., within 2 nm) of a bottom surface of the gate structure (or the top surface of dielectric layer 105). Since no portion of the gate structure extends below the top of dielectric subregion 104 (such that it would wrap around a portion of dielectric subregion 104), parasitic capacitance may be reduced.

### Fabrication Methodology

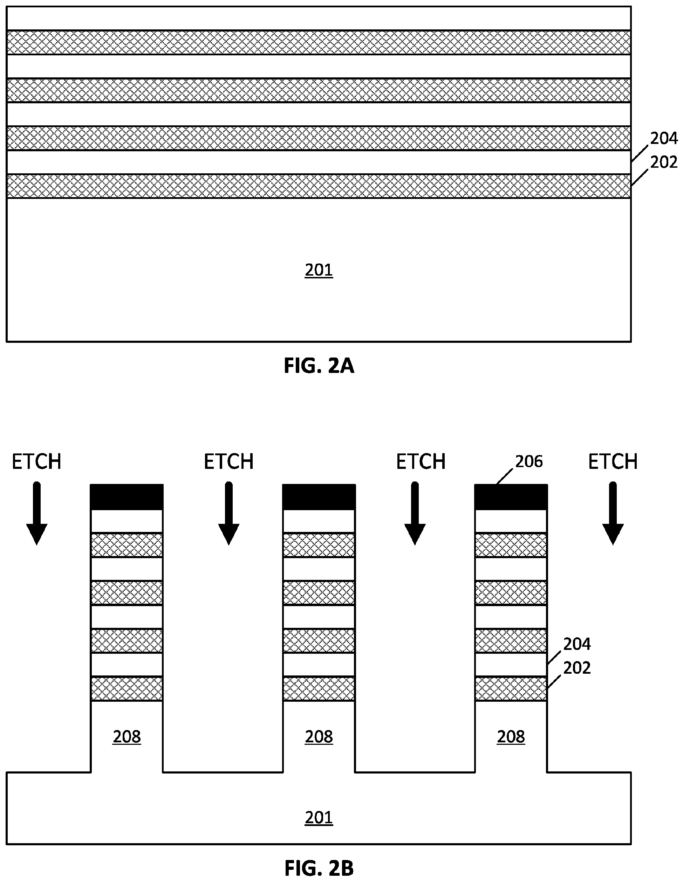

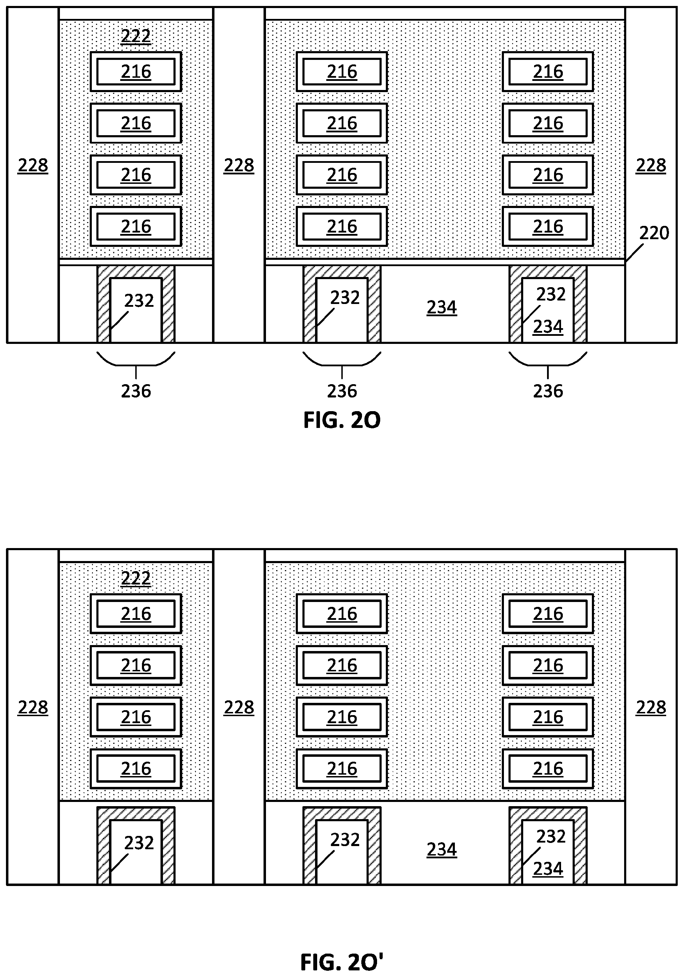

Figures 2A - 2O include cross-sectional views that collectively illustrate an example process for forming an integrated circuit with semiconductor devices having gate structures that do not extend below a top surface of dielectric subregions, in accordance with an embodiment of the present disclosure. Each figure shows an example structure that results from the process flow up to that point in time, so the depicted structure evolves as the process flow continues, culminating in the structure shown in Figure 2O, which is similar to the structure shown in Figure 1A. The illustrated integrated circuit structure may be part of a larger integrated circuit that includes other integrated circuitry not depicted. Example materials and process parameters are given, but the present disclosure is not intended to be limited to any specific such materials or parameters, as will be appreciated.

Figure 2A illustrates a cross-sectional view taken through a substrate 201 having a series of material layers formed over the substrate, according to an embodiment of the present disclosure. Substrate 201 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 201 can be a semiconductor-on-insulator substrate having a desired semiconductor layer over a buried insulator layer (e.g., silicon over silicon dioxide). Alternatively, substrate 201 can be a multilayer substrate or superlattice suitable for forming nanowires or nanoribbons (e.g., alternating layers of silicon and SiGe, or alternating layers indium gallium arsenide and indium phosphide). Any number of substrates can be used.

Alternating material layers may be deposited over substrate 201 including sacrificial layers 202 alternating with semiconductor layers 204. The alternating layers are used to form GAA transistor structures. Any number of alternating semiconductor layers 204 and sacrificial layers 202 may be deposited over substrate 201. According to some embodiments, sacrificial layers 202 have a different material composition than semiconductor layers 204. In some embodiments, sacrificial layers 202 are silicon germanium (SiGe) while semiconductor layers 204 include a semiconductor material suitable for use as a nanoribbon such as silicon (Si), SiGe, germanium, or III-V materials like indium phosphide (InP) or gallium arsenide (GaAs). In examples where SiGe is used in each of sacrificial layers 202 and in semiconductor layers 204, the germanium concentration is different between sacrificial layers 202 and semiconductor layers 204. For example, sacrificial layers 202 may include a higher germanium content compared to semiconductor layers 204.

While dimensions can vary from one example embodiment to the next, the thickness of each sacrificial layer 202 may be between about 5 nm and about 20 nm. In some embodiments, the thickness of each sacrificial layer 202 is substantially the same (e.g., within 1-2 nm). The thickness of each of semiconductor layers 204 may be about the same as the thickness of each sacrificial layer 202 (e.g., about 5-20 nm). Each of sacrificial layers 202 and semiconductor layers 204 may be deposited using any known or proprietary material deposition technique, such as chemical vapor deposition (CVD), plasma-enhanced chemical vapor deposition (PECVD), physical vapor deposition (PVD), or atomic layer deposition (ALD).

Figure 2B depicts the cross-section view of the structure shown in Figure 2A following the formation of a cap layer 206 and the subsequent formation of fins beneath cap layer 206, according to an embodiment. Cap layer 206 may be any suitable hard mask material such as a carbon hard mask (CHM) or silicon nitride. Cap layer 206 is patterned into rows to form corresponding rows of fins from the alternating layer stack of sacrificial layers 202 and semiconductor layers 204. The rows of fins extend lengthwise in a first direction (e.g., into and out of the page). According to some embodiments, an anisotropic etching process through the layer stack continues into at least a portion of substrate 201, which forms subfins 208 beneath the alternating layers 202/204. Subfins 208 may be the same material as substrate 201.

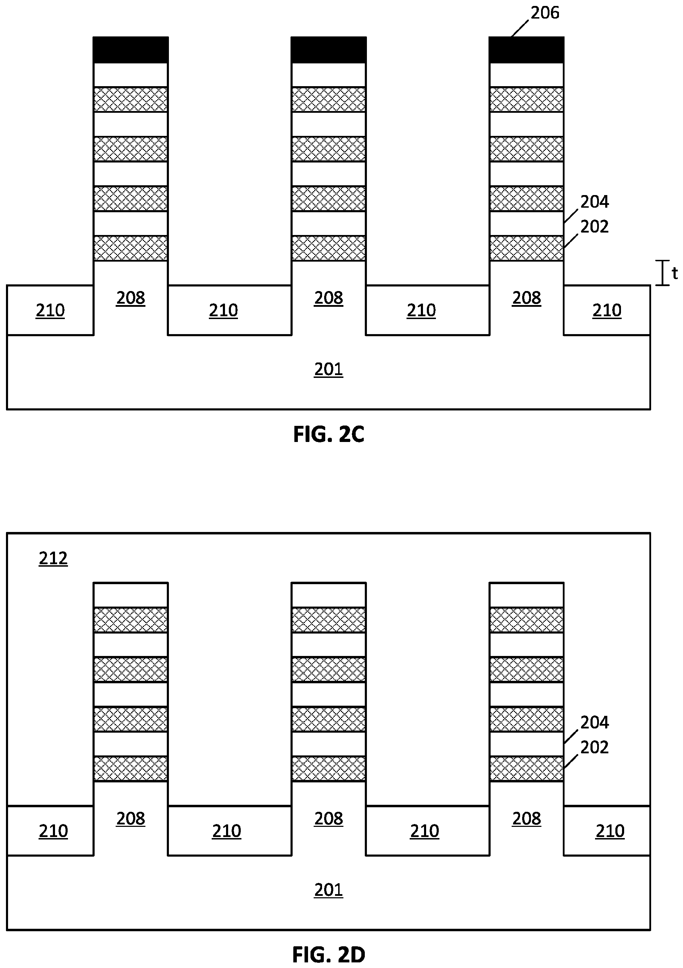

Figure 2C depicts the cross-section view of the structure shown in Figure 2B following the formation of a dielectric layer 210 between subfins 208, according to an embodiment. Dielectric layer 210 acts as shallow trench isolation (STI) between adjacent fins. Dielectric layer 210 may be any suitable dielectric material such as silicon dioxide. Subfins 208 may represent the portions of the fins directly adjacent to dielectric layer 210. According to some embodiments, dielectric layer 210 is recessed between the fins such that a top surface of dielectric layer 210 is below a top surface of subfins 208. For example, dielectric layer 210 may be recessed using any suitable isotropic etching technique to a final height that is a distance (t) below the top surface of subfins 208, wherein distance t is between about 3 nm and about 10 nm.

Note how in this example the fins have relatively straight sidewalls from the top of a given fin to the bottom of the subfin 208. Other examples may have an outward taper such that the fins are narrower at the top than they are at the bottom, with subfin 208 being the widest portion of a given fin. The degree of taper may vary depending on factors such as the etch process used and the height-to-width aspect ratio of the fins being formed. Higher etch directionality tends to yield a lower degree of taper.

Figure 2D depicts the cross-section view of the structure shown in Figure 2C following the formation of a sacrificial gate 212 extending across the fins in a second direction different from the first direction, according to some embodiments. Sacrificial gate 212 may extend across the fins in a second direction that is orthogonal to the first direction. According to some embodiments, the sacrificial gate material is formed in parallel strips across the integrated circuit and removed in all areas not protected by a gate masking layer. Sacrificial gate 212 may be any suitable material that can be selectively removed without damaging the semiconductor material of the fins. In some examples, sacrificial gate 212 includes polysilicon.

Following the formation of sacrificial gate 212 (and prior to replacement of sacrificial gate 212 with a metal gate), additional semiconductor device structures are formed that are not shown in these cross-sections. These additional structures include spacer structures on the sidewalls of sacrificial gate 212 and source and drain regions on either ends of each of the fins. The formation of such structures can be accomplished using any number of processing techniques.

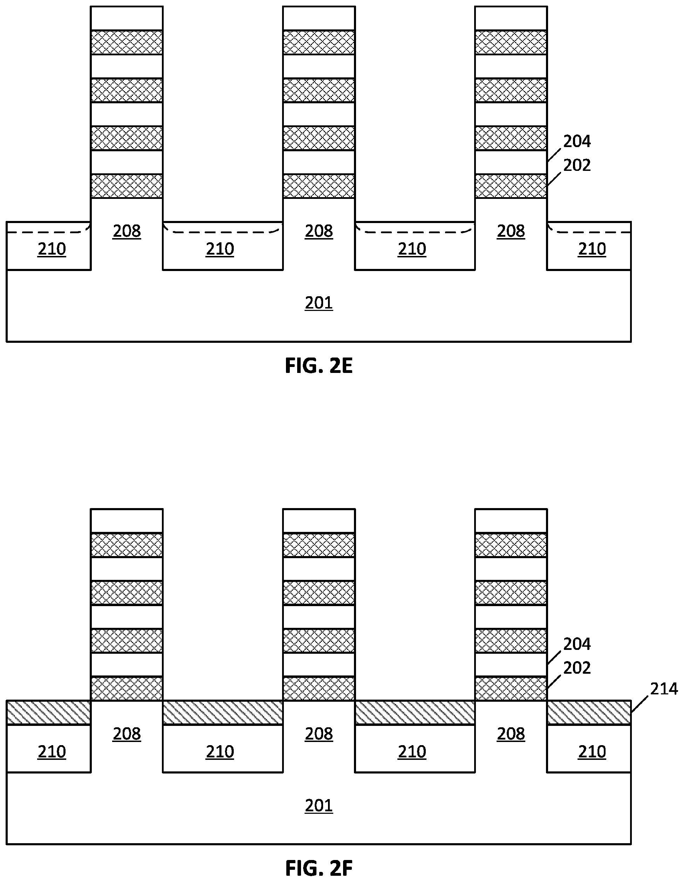

Figure 2E depicts the cross-section view of the structure shown in Figure 2D following the removal of sacrificial gate 212, according to some embodiments. In examples where any gate masking layers are still present, they may also be removed at this time. Once sacrificial gate 212 is removed, the fins that had been beneath sacrificial gate 212 are exposed.

According to some embodiments, the etching process(es) used to remove sacrificial gate 212 results in further recessing of dielectric layer 210. Accordingly, portions of the subfin sidewalls may be further exposed within the gate trench. It should be noted that the recessed dielectric layer 210 may have a parabolic or sloped surface near subfins 208, as indicated by the dashed lines.

Figure 2F depicts the cross-section view of the structure shown in Figure 2E following the formation of a sacrificial layer 214 along the bottom of the gate trench, according to some embodiments. Sacrificial layer 214 may include any suitable material that can be safely removed at a later time without damaging surrounding materials. In some examples, sacrificial layer 214 includes titanium nitride or aluminum oxide. Sacrificial material may be deposited within the gate trench and recessed to a final height using any suitable isotropic etching process to form sacrificial layer 214. According to some embodiments, a top surface of sacrificial layer 214 is substantially coplanar with (e.g., within 2 nm, or within 1 nm) of a top surface of subfins 208. The thickness of sacrificial layer 214 can vary from one example to the next, but in some examples is in the range of 2 nm to 20 nm.

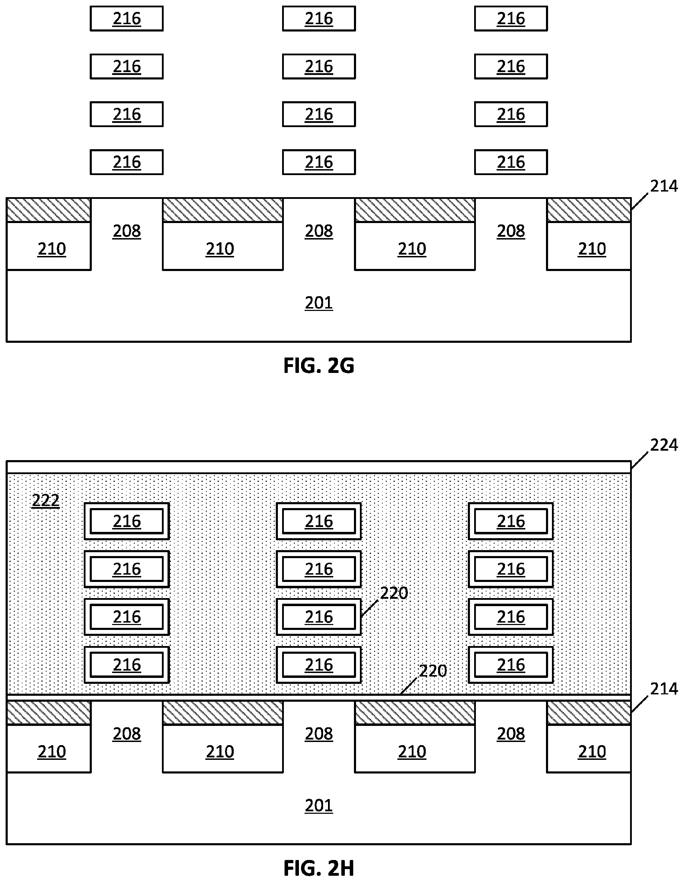

Figure 2G depicts the cross-section view of the structure shown in Figure 2F following the removal of sacrificial layers 202 to release nanoribbons 216, according to some embodiments. Each vertical set of nanoribbons 216 represents the semiconductor or channel region of a different semiconductor device. It should be understood that nanoribbons 216 may also be nanowires or nanosheets (e.g., from a forksheet arrangement) or fins (e.g., for a finFET arrangement). Any suitable isotropic etching process may be used to remove sacrificial layers 202 while removing little to none of semiconductor layers 204.

Figure 2H depicts the cross-section view of the structure shown in Figure 2G following the formation of a gate structure and subsequent polishing, according to some embodiments. The gate structure includes a gate dielectric 220 and a conductive gate electrode 222. Gate dielectric 220 may be first formed around nanoribbons 216 prior to the formation of gate electrode 222. The gate dielectric 220 may include any suitable dielectric material (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, gate dielectric 220 includes a layer of hafnium oxide with a thickness between about 1 nm and about 5 nm. In some embodiments, gate dielectric 220 may include one or more silicates (e.g., titanium silicate, tungsten silicate, niobium silicate, and silicates of other transition metals). In some cases, gate dielectric 220 may include a first layer on nanoribbons 216, and a second layer on the first layer. The first layer can be, for instance, an oxide of the semiconductor material of nanoribbons 216 (e.g., silicon dioxide) and the second layer can be a high-k dielectric material (e.g., hafnium oxide). More generally, gate dielectric 220 can include any number of dielectric layers. According to some embodiments, gate dielectric 220 forms along all surfaces exposed within the gate trench, such as along inner sidewalls of the spacer structures and along the top surfaces of sacrificial layer 214 and subfins 208. Note that the presence of sacrificial layer 214 prevents any portion of gate dielectric 220 forming below the top surface of subfins 208, according to some embodiments.

As noted above, gate electrode 222 can represent any number of conductive layers. The conductive gate electrode 222 may be deposited using electroplating, electroless plating, CVD, PECVD, ALD, or PVD, to name a few examples. In some embodiments, gate electrode 222 includes doped polysilicon, a metal, or a metal alloy. Example suitable metals or metal alloys include aluminum, tungsten, cobalt, molybdenum, ruthenium, titanium, tantalum, copper, and carbides and nitrides thereof. Gate electrode 222 may include, for instance, a metal fill material along with one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates. Following the formation of the gate structure, the entire structure may be polished or planarized such that the top surface of the gate structure (e.g., top surface of gate electrode 222) is planar with the top surface of other semiconductor elements, such as the spacer structures that define the gate trench.

According to some embodiments, a gate cap 224 may be formed on the top surface of gate electrode 222. Gate cap 224 may be any suitable dielectric material, such as silicon nitride, silicon dioxide, or silicon oxynitride. In some examples, gate electrode 222 is recessed below a top surface of the adjacent spacer structures and gate cap 224 is formed within the recess and polished such that a top surface of gate cap 224 is substantially coplanar with a top surface of the adjacent spacer structures.

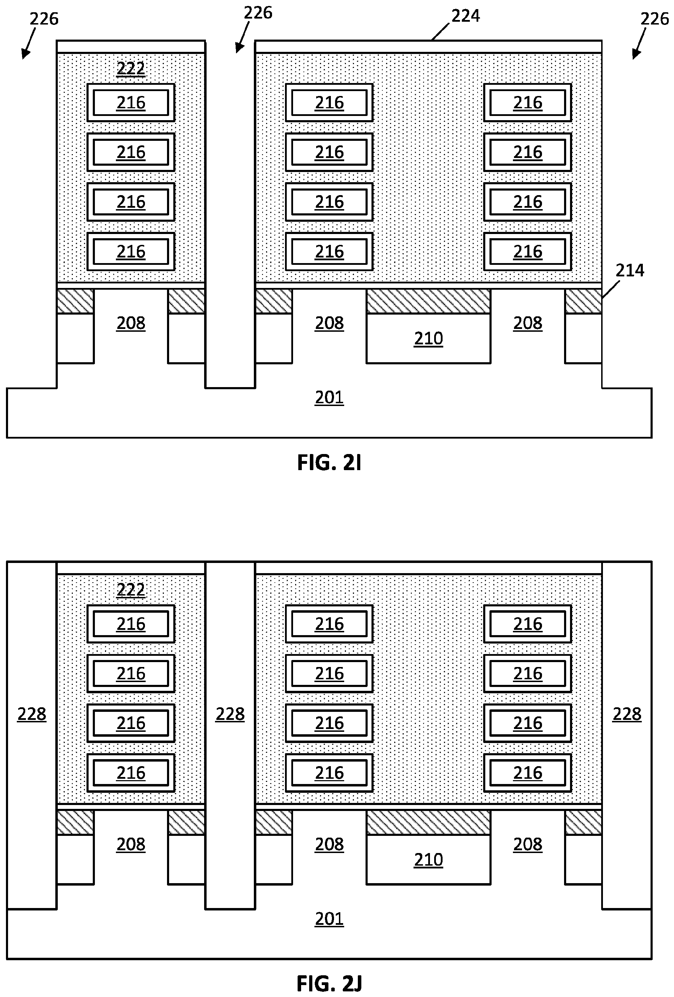

Figure 2I depicts the cross-section view of the structure shown in Figure 2H following the formation of a gate cut recesses 226 through at least an entire thickness of gate electrode 222, according to some embodiments. Gate cut recesses 226 may have a high height-to-width aspect ratio of 5:1 or more, such as between 6:1 and 10:1 and may be formed via a series of RIE and passivation steps to etch through the conductive material of gate electrode 222. Gate cut recesses 226 may be tapered and have a largest width along a top surface of gate electrode 222 between about 40 nm and about 50 nm. In some embodiments, gate cut recesses 226 extend through at least a portion of an entire thickness of dielectric layer 210. In some embodiments, gate cut recesses 226 extend through the entire thickness of dielectric layer 210 and into the underlying substrate 201. Gate cut recesses 226 may be trench-shaped recesses that extend in the first direction between any number of device pairs. Note that gate cut recesses 226 also extend through at least a portion of or an entire thickness of sacrificial layer 214, according to some embodiments.

Figure 2J illustrates another cross-section view of the structure shown in Figure 2I following the formation of gate cuts 228 within gate cut recesses 226, according to some embodiments. Gate cuts 228 may each include a single dielectric material, or may include a dielectric liner and dielectric fill on the dielectric liner. The dielectric liner may include a high-k dielectric material, such as silicon nitride or silicon carbide or any other material having a dielectric constant of at least 6.5. The dielectric fill may be a low-k dielectric material, such as silicon dioxide or flowable oxide or any other material having a dielectric constant of at most 4.5. A top surface of gate cuts 228 may be polished using chemical mechanical polishing (CMP), to be substantially coplanar with a top surface of gate cap 224, according to some embodiments.

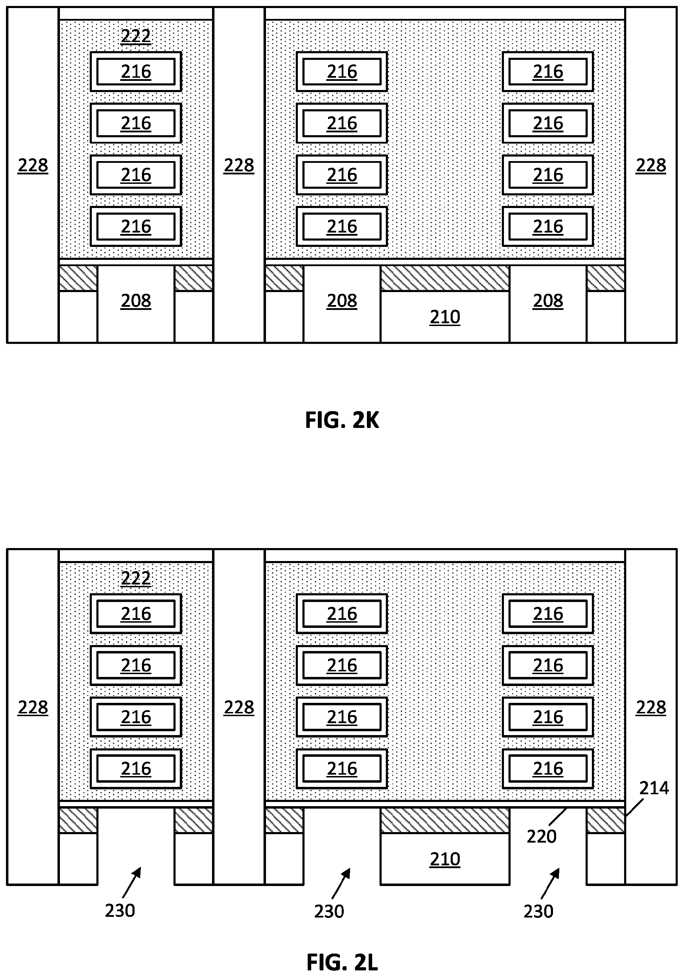

Figure 2K illustrates another cross-section view of the structure shown in Figure 2J following the removal of substrate 201 from the backside of the structure, according to some embodiments. Substrate 201 may be removed via any combination of grinding, polishing, and/or etching processes. In some embodiments, substrate 201 may continue to be thinned (e.g., via CMP) from the backside until bottom surfaces of dielectric layer 210 and/or subfins 208 adjacent to dielectric layer 210 are exposed. In some examples, the only portions of the semiconductor material from substrate 201 left behind following the backside removal process are found within subfins 208.

Figure 2L illustrates another cross-section view of the structure shown in Figure 2K following the removal of subfin 208 from the backside, according to some embodiments. An isotropic etching process may be used to selectively remove the exposed semiconductor material of subfin 208 while removing substantially little or none of the exposed dielectric materials, such as dielectric layer 210 and any portion of gate cuts 228. According to some embodiments, the etching process stops or is otherwise slowed by the presence of gate dielectric 220 (which may act like an etch stop). According to some embodiments, the removal of subfins 208 forms backside cavities 230 aligned beneath nanoribbons 216. Sidewall surfaces of sacrificial layer 214 may be exposed within backside cavities 230, according to some embodiments.

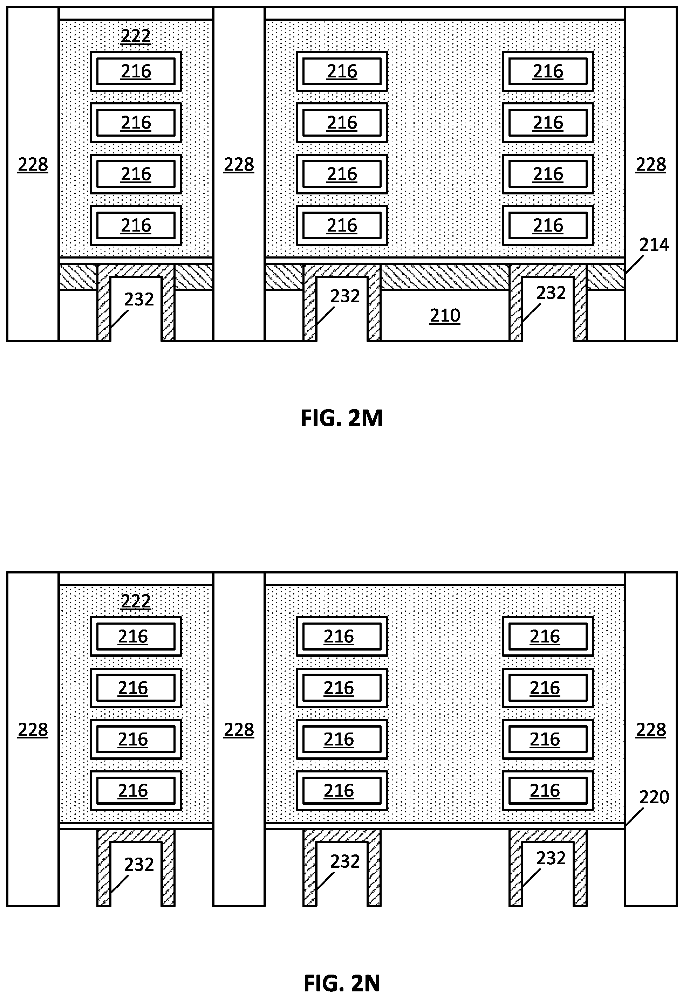

Figure 2M illustrates another cross-section view of the structure shown in Figure 2L following the formation of a dielectric liner 232 within backside cavities 230, according to some embodiments. Dielectric liner 232 may be any suitable dielectric material that is different than the materials of dielectric layer 210 and sacrificial layer 214, such that those layers can be selectively removed without substantially removing dielectric liner 232, as further described below. In one example, dielectric liner 232 comprises silicon nitride and dielectric layer 210 comprises silicon dioxide, and sacrificial layer 214 comprises titanium nitride or aluminum oxide or a carbide. Dielectric liner 232 may be conformally deposited within backside cavities 230 using CVD or ALD. In some embodiments, dielectric liner 232 is formed directly on a bottom surface of gate dielectric 220. The thickness of dielectric liner 232 may be, for example, in the range of 2 nm to 8 nm. In other examples, dielectric liner 232 completely fills recesses 230, so as to provide a plug rather than a liner. Any excess deposition of dielectric liner 232 (e.g., on backsides of dielectric layer 210 and gate cuts 228) may be removed, for example, via a CMP process.

Figure 2N illustrates another cross-section view of the structure shown in Figure 2M following the backside removal of dielectric layer 210 and sacrificial layer 214, according to some embodiments. Dielectric layer 210 and sacrificial layer 214 may be removed using one or more isotropic etching processes, that are selective to dielectric liner 232. In some examples, backside exposed portions of gate cuts 228 may also be partially removed by the etch. According to some embodiments, the etch process may be tailored to not attach the dielectric material of gate dielectric 220, such that gate dielectric 220 remains along the bottom of the gate trench. In such an example, gate dielectric 220 effectively provides an etch stop.

Figure 2O illustrates another cross-section view of the structure shown in Figure 2N following the formation of a backside dielectric fill 234 that fills the region between dielectric liner 232 within backside cavities 230 to form dielectric subregions 236, and also fills backside regions between dielectric subregions 236, according to some embodiments. Dielectric fill 234 may include any suitable dielectric material, such as silicon dioxide or silicon nitride. A bottom surface of dielectric fill 234 may be polished using CMP to be substantially planar, so as to prepare the structure for provisioning of a backside interconnect structure which may include, for instance, one or more interconnect layers configured with power delivery and/or signal routing networks. Recall from above that dielectric liner 232 may fill cavities to provide a plug, rather than just a liner. Such a liner or plug feature can be selectively removed (along with any exposed remaining gate dielectric 220) in a backside interconnect process, according to some such embodiments. In the case of a dielectric liner surrounding a separate dielectric fill (e.g., silicon nitride liner with silicon dioxide fill), selective etching of the liner material may effectively also remove the fill material. The resulting recess can then be filled with a contact structure (e.g., conductive plug or a conductive liner/fill structure).

As noted above, gate dielectric 220 may remain along the bottom of the gate trench as illustrated in Figure 2O. In some other embodiments, gate dielectric 220 is removed using an isotropic etching process during the removal of sacrificial layer 214 or following the removal of sacrificial layer 214. Figure 2O' illustrates the example structure with gate dielectric 220 having been removed from the backside. In some embodiments, dielectric fill 234 may also be deposited between the top surface of dielectric liner 232 and the bottom surface of gate electrode 222. In some embodiments, dielectric liner 232 is formed directly against the bottom surface of gate electrode 222 (e.g., gate dielectric 220 is removed from within backside cavity 230 prior to the formation of dielectric liner 232). The above description with respect to backside contacts is equally applicable here, where a given backside contact structure contacts the bottom gate electrode surface of the overlying gate structure. Note that some gate electrodes may be backside contacted in this manner, while other adjacent gate electrodes may not be backside contacted and just have a dielectric subregion (232, or 232 and 234) instead.

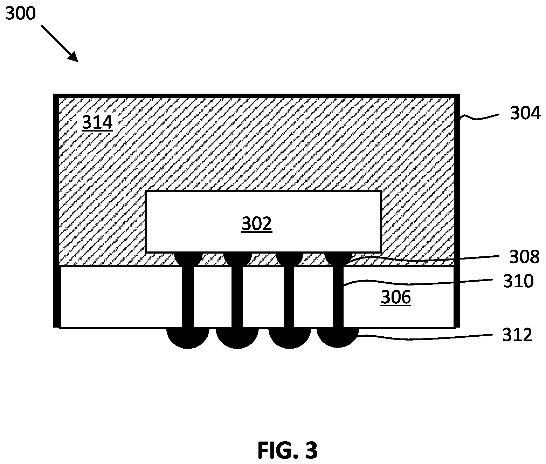

Figure 3 illustrates an example embodiment of a chip package 300, in accordance with an embodiment of the present disclosure. As can be seen, chip package 300 includes one or more dies 302. One or more dies 302 may include at least one integrated circuit having semiconductor devices, such as any of the semiconductor devices disclosed herein. One or more dies 302 may include any other circuitry used to interface with other devices formed on the dies, or other devices connected to chip package 300, in some example configurations.

As can be further seen, chip package 300 includes a housing 304 that is bonded to a package substrate 306. The housing 304 may be any standard or proprietary housing, and may provide, for example, electromagnetic shielding and environmental protection for the components of chip package 300. The one or more dies 302 may be conductively coupled to a package substrate 306 using connections 308, which may be implemented with any number of standard or proprietary connection mechanisms, such as solder bumps, ball grid array (BGA), pins, or wire bonds, to name a few examples. Package substrate 306 may be any standard or proprietary package substrate, but in some cases includes a dielectric material having conductive pathways (e.g., including conductive vias and lines) extending through the dielectric material between the faces of package substrate 306, or between different locations on each face. In some embodiments, package substrate 306 may have a thickness less than 1 millimeter (e.g., between 0.1 millimeters and 0.5 millimeters), although any number of package geometries can be used. Additional conductive contacts 312 may be disposed at an opposite face of package substrate 306 for conductively contacting, for instance, a printed circuit board (PCB). One or more vias 310 extend through a thickness of package substrate 306 to provide conductive pathways between one or more of connections 308 to one or more of contacts 312. Vias 310 are illustrated as single straight columns through package substrate 306 for ease of illustration, although other configurations can be used (e.g., damascene, dual damascene, through-silicon via, or an interconnect structure that meanders through the thickness of substrate 306 to contact one or more intermediate locations therein). In still other embodiments, vias 310 are fabricated by multiple smaller stacked vias, or are staggered at different locations across package substrate 306. In the illustrated embodiment, contacts 312 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 312, to inhibit shorting.

In some embodiments, a mold material 314 may be disposed around the one or more dies 302 included within housing 304 (e.g., between dies 302 and package substrate 306 as an underfill material, as well as between dies 302 and housing 304 as an overfill material). Although the dimensions and qualities of the mold material 314 can vary from one embodiment to the next, in some embodiments, a thickness of mold material 314 is less than 1 millimeter. Example materials that may be used for mold material 314 include epoxy mold materials, as suitable. In some cases, the mold material 314 is thermally conductive, in addition to being electrically insulating.

### Methodology

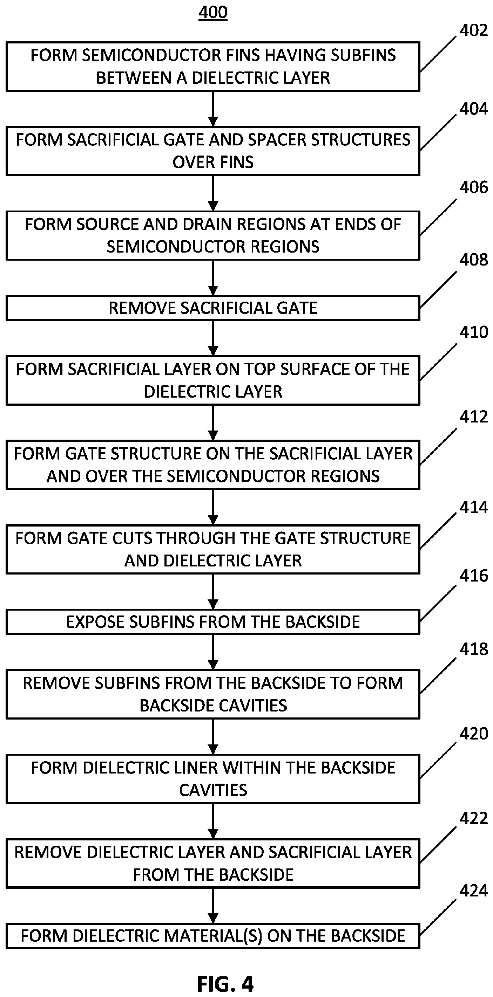

Figure 4 is a flow chart of a method 400 for forming at least a portion of an integrated circuit, according to an embodiment. Various operations of method 400 may be illustrated in Figures 2A - 2O (or 2O'). However, the correlation of the various operations of method 400 to the specific components illustrated in the aforementioned figures is not intended to imply any structural and/or use limitations. Rather, the aforementioned figures provide one example embodiment of method 400. Other operations may be performed before, during, or after any of the operations of method 400. For example, method 400 does not explicitly describe all processes that are performed to form common transistor structures. Some of the operations of method 400 may be performed in a different order than the illustrated order.

Method 400 begins with operation 402 where any number of parallel semiconductor fins are formed, according to some embodiments. The semiconductor material in the fins may be formed from a substrate such that the fins are an integral part of the substrate (e.g., etched from a bulk silicon substrate). Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. The alternating layers can be blanket deposited and then etched into fins or deposited into fin-shaped trenches. The fins may also include a cap structure over each fin that is used to define the locations of the fins during, for example, an RIE process. The cap structure may be a dielectric material, such as silicon nitride.

According to some embodiments, a base dielectric layer is formed around subfin portions of the one or more fins. In some embodiments, the base dielectric layer extends between each pair of adj acent parallel fins and runs lengthwise in the same direction as the fins. In some embodiments, the anisotropic etching process that forms the fins also etches into a portion of the substrate and the base dielectric layer may be formed within the recessed portions of the substrate. Accordingly, the base dielectric layer acts as shallow trench isolation (STI) between adjacent fins. The base dielectric layer may be any suitable dielectric material, such as silicon dioxide. Lower portions of the fins adjacent to the base dielectric layer may be identified as the subfins. According to some embodiments, the base dielectric layer is recessed such that a top surface of the base dielectric layer is below a top surface of the subfins.

Method 400 continues with operation 404 where a sacrificial gate and spacer structures are formed over the fins. The sacrificial gate may be patterned using a gate masking layer in a strip that runs orthogonally over the fins (many gate masking layers and corresponding sacrificial gates may be formed parallel to one another (e.g., forming a cross-hatch pattern with the fins). The gate masking layer may be any suitable hard mask material, such as CHM or silicon nitride. The sacrificial gate may be formed from any suitable material that can be selectively removed at a later time without damaging the semiconductor material of the fins. In one example, the sacrificial gate includes polysilicon. The spacer structures may be deposited and then etched back such that the spacer structures remain mostly only on sidewalls of any exposed structures. According to some embodiments, the spacer structures may be any suitable dielectric material, such as silicon nitride, silicon oxynitride, or silicon oxycarbide.

Method 400 continues with operation 406 where source or drain regions are formed at the ends of the semiconductor regions of each of the fins. Any portions of the fins not protected by the sacrificial gate and spacer structures may be removed using, for example, an anisotropic etching process followed by the epitaxial growth of the source or drain regions from the exposed ends of the semiconductor layers in the fins. In some example embodiments, the source or drain regions are NMOS source or drain regions (e.g., epitaxial silicon) or PMOS source or drain regions (e.g., epitaxial SiGe). Another dielectric fill may be formed adjacent to the various source or drain regions for additional electrical isolation between adjacent regions. The dielectric fill may also extend over a top surface of the source or drain regions. In some embodiments, topside conductive contacts may be formed through the dielectric fill to contact one or more of the source or drain regions.

Method 400 continues with operation 408 where the sacrificial gate is removed. The sacrificial gate may be removed using an isotropic etching process that selectively removes all of the material from the sacrificial gate, thus exposing the various fins between the set of spacer structures. According to some embodiments, the removal of the sacrificial gate can cause further recessing of the base dielectric layer further below the top surface of the subfins.

Method 400 continues with operation 410 where a sacrificial layer is formed along the bottom of the gate trench. According to some embodiments, the sacrificial layer forms along the top surface of the base dielectric layer and is adjacent to portions of the subfins that extend into the gate trench. The sacrificial layer may be deposited in the gate trench and recessed using a suitable isotropic etching process until its top surface is substantially coplanar (e.g., within 2 nm or 1 nm) with the top surface of the subfins. The sacrificial layer may be any suitable material that can be safely removed at a later time without damaging surrounding material structures. In some examples, the sacrificial layer includes titanium nitride or aluminum oxide.

Method 400 continues with operation 412 where a gate structure is formed in the gate trench over the sacrificial layer. In the example case where GAA transistors are used, any sacrificial layers within the exposed fins between the spacer structures may be removed prior to the formation of the gate structure to release nanoribbons, nanosheets, or nanowires of semiconductor material. The gate structure may include both a gate dielectric and a gate electrode. The gate dielectric is first formed over the exposed semiconductor regions between the spacer structures followed by forming the gate electrode within the remainder of the trench between the spacer structures, according to some embodiments. The gate dielectric may include any number of dielectric layers deposited using a CVD process, such as ALD. The gate electrode can include any number of conductive material layers, such as any metals, metal alloys, or polysilicon. The gate electrode may be deposited using electroplating, electroless plating, CVD, ALD, PECVD, or PVD, to name a few examples. In some embodiments, the gate electrode may be recessed, and a dielectric gate cap is formed within the recessed area.

Method 400 continues with operation 414 where gate cuts are formed through the gate structures between adjacent devices. The gate cuts are dielectric structures that may include any number of dielectric materials. In some embodiments, a trench recess is formed through an entire thickness of the gate structure and through at least a portion of an entire thickness of the sacrificial layer and base dielectric layer beneath the gate structure. The trench extends in the first direction between any number of devices.

According to some embodiments, the trench recesses may be filled with at least a dielectric liner and a dielectric fill on the dielectric liner to form the dielectric structures. In some examples, the dielectric liner includes a high-k dielectric material, such as silicon nitride or silicon carbide or any other material having a dielectric constant of at least 6.5. The dielectric liner may be, for example, conformally deposited using ALD to a thickness between about 2 nm and about 4 nm. The dielectric fill may be formed directly on the dielectric liner. According to some embodiments, the dielectric fill includes a low-k dielectric material, such as silicon dioxide or flowable oxide or any other material having a dielectric constant of at most 4.5. The dielectric fill may be deposited using any suitable plasma deposition technique, such as CVD.

Method 400 continues with operation 416 where the substrate is removed from the backside of the structure. The substrate may be removed via any combination of grinding, polishing, and/or etching processes. In some embodiments, the substrate is thinned away at least up until bottom surfaces of the base dielectric layer and/or subfins adj acent to the base dielectric layer are exposed. In some examples, the only portions of the semiconductor material from the substrate left behind following the backside removal process are in the subfins.

Method 400 continues with operation 418 where the subfins are removed from the backside to form backside cavities. According to some embodiments, an isotropic etching process that removes the semiconductor region and stops at the gate dielectric can be used to selectively remove the semiconductor material of the subfins while removing little to none of the surrounding dielectric materials. According to some embodiments, the removal of the subfins exposes portions of the base dielectric layer and portions of the sacrificial layer along sidewalls of the backside cavities.

Method 400 continues with operation 420 where a dielectric liner is formed within the backside cavities. The dielectric liner may be formed over all surfaces of the backside cavities The dielectric liner may be any suitable dielectric material that is different from the base dielectric layer. In one example, the dielectric liner includes silicon nitride and the base dielectric layer includes silicon dioxide. In some embodiments, a dielectric material is used to substantially fill the backside cavities, such as with silicon nitride, so as to provide a plug rather than a liner.

Method 400 continues with operation 422 where both the base dielectric layer and the sacrificial layer are removed from the backside. Each of base dielectric layer and sacrificial layer may be removed using a suitable isotropic etching process. The removal of the base dielectric layer and sacrificial layer leaves behind the dielectric liner or plug within the cavities as defining the locations of dielectric subregions on the backside of the structure. The backside removal of the sacrificial layer reveals the gate dielectric, which may act as an etch stop in some embodiments, or may also be removed according to some other embodiments.

Method 400 continues with operation 424 where one or more dielectric materials are formed on the backside. According to some embodiments, a backside dielectric fill is used to fill the region between the dielectric liner (if not already filled with liner material) where the backside cavities were to form dielectric subregions. The backside dielectric fill also fills backside regions between the dielectric subregions beneath the gate structure, according to some embodiments. The backside dielectric fill may include any suitable dielectric material, such as silicon dioxide, or any number of different dielectric materials. A bottom surface of the backside dielectric fill may be polished using CMP to be substantially planar. A backside interconnect structure may be formed on that bottom surface, to provide routing of power and signals. Further recall that the dielectric liner may be selectively removed in one or more locations, so as to allow for provisioning of one or more backside gate contacts. In an example, a given backside contact may include, for instance, a conductive plug, or a structure that includes a conductive liner or barrier layer (e.g., tantalum or titanium nitride) and a conductive fill material (e.g., tungsten, ruthenium, molybdenum, copper, aluminum).

### Example System

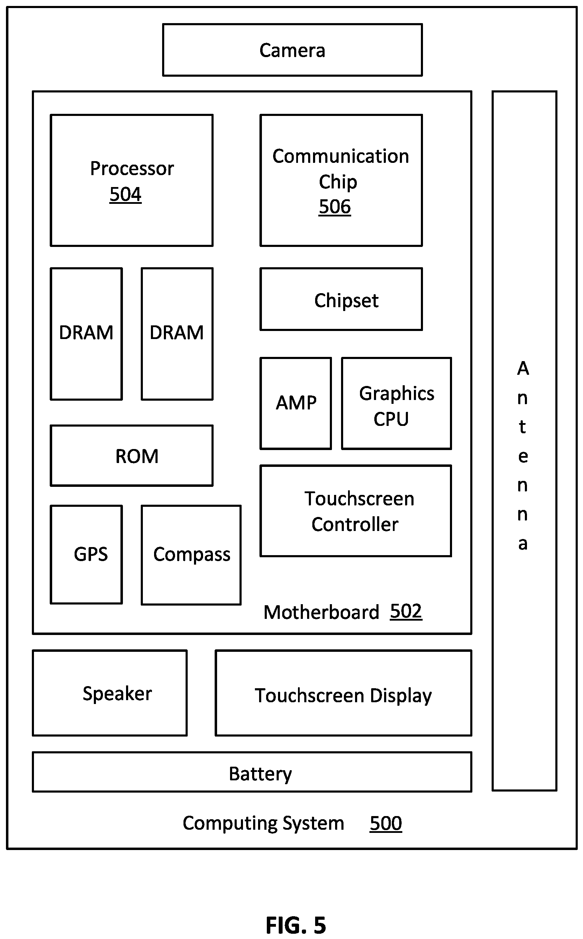

FIG. 5 is an example computing system implemented with one or more of the integrated circuit structures as disclosed herein, in accordance with some embodiments of the present disclosure. As can be seen, the computing system 500 houses a motherboard 502. The motherboard 502 may include a number of components, including, but not limited to, a processor 504 and at least one communication chip 506, each of which can be physically and electrically coupled to the motherboard 502, or otherwise integrated therein. As will be appreciated, the motherboard 502 may be, for example, any printed circuit board (PCB), whether a main board, a daughterboard mounted on a main board, or the only board of system 500, etc.

Depending on its applications, computing system 500 may include one or more other components that may or may not be physically and electrically coupled to the motherboard 502. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 500 may include one or more integrated circuit structures or devices configured in accordance with an example embodiment, such as a module including an integrated circuit on a substrate, the substrate having semiconductor devices with gate structures that do not extend below a top surface of dielectric subregions, such as shown in the examples of Figures 1A, 2O, and 2O'. In some embodiments, multiple functions can be integrated into one or more chips (e.g., for instance, note that the communication chip 506 can be part of or otherwise integrated into the processor 504).

The communication chip 506 enables wireless communications for the transfer of data to and from the computing system 500. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 506 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 500 may include a plurality of communication chips 506. For instance, a first communication chip 506 may be dedicated to shorter range wireless communications such as Wi-Fi and Bluetooth and a second communication chip 506 may be dedicated to longer range wireless communications such as GPS, EDGE, GPRS, CDMA, WiMAX, LTE, Ev-DO, and others.

The processor 504 of the computing system 500 includes an integrated circuit die packaged within the processor 504. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 506 also may include an integrated circuit die packaged within the communication chip 506. In accordance with some such example embodiments, the integrated circuit die of the communication chip includes one or more semiconductor devices as variously described herein. As will be appreciated in light of this disclosure, note that multistandard wireless capability may be integrated directly into the processor 504 (e.g., where functionality of any chips 506 is integrated into processor 504, rather than having separate communication chips). Further note that processor 504 may be a chip set having such wireless capability. In short, any number of processor 504 and/or communication chips 506 can be used. Likewise, any one chip or chip set can have multiple functions integrated therein.

In various implementations, the computing system 500 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 500 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a semiconductor region extending from a source or drain region in a first direction, a gate structure extending over the semiconductor region in a second direction different from the first direction, and a subregion beneath the semiconductor region. No portion of the gate structure extends below a topmost surface of the subregion and at least a portion of the gate structure contacts the topmost surface of the subregion.

Example 2 includes the integrated circuit of Example 1, wherein the subregion comprises a dielectric liner along edges of the subregion.

Example 3 includes the integrated circuit of Example 2, wherein the subregion further comprises a dielectric fill within at least a portion of a remaining volume of the subregion and on the dielectric liner.

Example 4 includes the integrated circuit of Example 3, wherein the dielectric fill comprises silicon and any one of nitrogen, carbon, or oxygen.

Example 5 includes the integrated circuit of any one of Examples 2-4, wherein the dielectric liner comprises silicon and nitrogen.

Example 6 includes the integrated circuit of any one of Examples 1-5, wherein the subregion comprises a conductive contact structure in contact with a bottom surface of the gate structure.

Example 7 includes the integrated circuit of any one of Examples 1-6, wherein the gate structure comprises a gate electrode and a gate dielectric, and wherein no portion of the gate dielectric is on the topmost surface of the subregion.

Example 8 includes the integrated circuit of Example 7, wherein the gate dielectric comprises hafnium and oxygen.

Example 9 includes the integrated circuit of any one of Examples 1-8, wherein the semiconductor region comprises one or more semiconductor nanoribbons.

Example 10 includes the integrated circuit of Example 9, wherein the one or more semiconductor nanoribbons comprises germanium, silicon, or any combination thereof.

Example 11 includes the integrated circuit of any one of Examples 1-10, further comprising a dielectric structure extending through the gate structure in the first direction and adjacent to the semiconductor region, the dielectric structure also extending in a third direction through an entire thickness of the gate structure and along at least a portion of an entire thickness of the subregion.

Example 12 includes the integrated circuit of Example 11, further comprising a dielectric layer laterally adjacent to the subregion and between the subregion and the dielectric structure.

Example 13 includes the integrated circuit of any one of Examples 1-12, further comprising dielectric fill laterally adjacent to and contacting the subregion, wherein the dielectric fill comprises a first dielectric material, and the subregion comprises a second dielectric material that is compositionally different from the first dielectric material, and wherein the first dielectric material is etch selective with respect to the second dielectric material.

Example 14 includes the integrated circuit of any one of Examples 1-12, further comprising dielectric fill laterally adjacent to and contacting the subregion, wherein the subregion comprises a contact structure in contact with the gate structure.

Example 15 is a printed circuit board comprising the integrated circuit of any one of Examples 1-14.

Example 16 is an electronic device that includes a chip package having one or more dies. At least one of the one or more dies includes a semiconductor device having a semiconductor region extending in a first direction from a source or drain region and a gate structure extending over the semiconductor region in a second direction different from the first direction, and a subregion beneath the semiconductor region. The subregion includes a dielectric liner along edges of the subregion, and a dielectric fill within at least a portion of a remaining volume of the subregion. No portion of the gate structure extends below a topmost surface of the subregion and at least a portion of the gate structure contacts the topmost surface of the subregion.

Example 17 includes the electronic device of Example 16, wherein the gate structure comprises a gate electrode and a gate dielectric, and wherein no portion of the gate dielectric is on the topmost surface of the subregion.

Example 18 includes the electronic device of Example 17, wherein the gate dielectric comprises hafnium and oxygen.

Example 19 includes the electronic device of any one of Examples 16-18, wherein the dielectric liner comprises silicon and nitrogen.

Example 20 includes the electronic device of any one of Examples 16-19, wherein the dielectric fill comprises silicon and any one of nitrogen, carbon, or oxygen.

Example 21 includes the electronic device of any one of Examples 16-20, wherein the semiconductor region comprises one or more semiconductor nanoribbons.

Example 22 includes the electronic device of Example 21, wherein the one or more semiconductor nanoribbons comprises germanium, silicon, or any combination thereof.

Example 23 includes the electronic device of any one of Examples 16-22, wherein the at least one of the one or more dies further comprises a dielectric structure extending through the gate structure in the first direction and adjacent to the semiconductor region, the dielectric structure also extending in a third direction through an entire thickness of the gate structure and along at least a portion of an entire thickness of the subregion.

Example 24 includes the electronic device of Example 23, wherein the at least one of the one or more dies further comprises a dielectric layer laterally adjacent to the subregion and between the subregion and the dielectric structure.

Example 25 includes the electronic device of any one of Examples 16-24, further comprising a printed circuit board, wherein the chip package is attached to the printed circuit board.

Example 26 is a method of forming an integrated circuit. The method includes forming a multilayer fin extending in a first direction over a substrate having a device section with first material layers alternating with second material layers, and a subfin beneath the device section; forming a dielectric layer adjacent to the subfin; forming a sacrificial layer on a top surface of the dielectric layer adjacent to a top portion of the subfin; forming a gate structure on the sacrificial layer and extending in a second direction over the first material layers after removing the second material layers of the multilayer fin; removing a portion of the substrate from the backside to expose a bottom surface of the subfin and a bottom surface of the dielectric layer; removing the subfin from the backside to form a backside cavity; forming a dielectric liner within the backside cavity; removing the dielectric layer from the backside to expose a bottom surface of the sacrificial layer; removing the sacrificial layer from the backside; and forming one or more dielectric materials within the backside cavity and adjacent to the backside cavity.

Example 27 includes the method of Example 26, further comprising forming a sacrificial gate extending in a second direction over the device section of the multilayer fin; forming spacer structures on sidewalls of the sacrificial gate; and forming source or drain regions at the exposed ends of the first material layers of the multilayer fin.

Example 28 includes the method of Example 26 or 27, wherein the sacrificial layer comprises titanium nitride.

Example 29 includes the method of any one of Examples 26-28, wherein the sacrificial layer has a thickness between about 5 nm and about 10 nm.

Example 30 includes the method of any one of Examples 26-29, wherein the gate structure comprises a gate electrode on a gate dielectric, the method further comprising removing a portion of the gate dielectric after removing the sacrificial layer from the backside.

Example 31 includes the method of any one of Examples 26-30, wherein the dielectric liner comprises silicon and nitrogen and the one or more dielectric materials comprises silicon and oxygen.

Example 32 is an integrated circuit that includes a semiconductor region extending in a first direction, a gate structure extending over the semiconductor region in a second direction different from the first direction, a dielectric layer beneath the gate structure, and a subregion beneath the semiconductor region and laterally adjacent to the dielectric layer. A top surface of the subregion is substantially coplanar with a top surface of the dielectric layer.

Example 33 includes the integrated circuit of Example 32, wherein the gate structure comprises a gate electrode and a gate dielectric, and wherein at least a portion of the gate dielectric is on the top surface of the dielectric layer.

Example 34 includes the integrated circuit of Example 33, wherein the gate dielectric comprises hafnium and oxygen.

Example 35 includes the integrated circuit of Example 32, wherein the gate structure comprises a gate electrode and a gate dielectric, and wherein no portion of the gate dielectric is on the subregion.

Example 36 includes the integrated circuit of any one of Examples 32-35, wherein the dielectric layer comprises silicon and oxygen.

Example 37 includes the integrated circuit of any one of Examples 32-36, wherein the semiconductor region comprises one or more semiconductor nanoribbons.

Example 38 includes the integrated circuit of Example 37, wherein the one or more semiconductor nanoribbons comprises germanium, silicon, or any combination thereof.

Example 39 includes the integrated circuit of any one of Examples 32-38, further comprising a dielectric structure extending through the gate structure in the first direction and adjacent to the semiconductor region, the dielectric structure also extending in a third direction through an entire thickness of the gate structure and along at least a portion of an entire thickness of the subregion.

Example 40 includes the integrated circuit of Example 39, wherein the dielectric layer is between the subregion and the dielectric structure.

Example 41 includes the integrated circuit of any one of Examples 32-40, wherein no portion of the gate structure extends below a topmost surface of the subregion and at least a portion of the gate structure contacts the topmost surface of the dielectric subregion.

Example 42 includes the integrated circuit of any one of Examples 32-41, wherein the subregion is a dielectric subregion.

Example 43 includes the integrated circuit of any one of Examples 32-41, wherein the subregion is a conductive subregion.

Example 44 includes the integrated circuit of any one of Examples 32-42, wherein the subregion comprises a dielectric liner along edges of the subregion.

Example 45 includes the integrated circuit of Example 44, wherein the subregion further comprises a dielectric fill within at least a portion of a remaining volume of the subregion and on the dielectric liner.

Example 46 includes the integrated circuit of Example 45, wherein the dielectric fill comprises silicon and any one of nitrogen, carbon, or oxygen.

Example 47 includes the integrated circuit of any one of Examples 44-46, wherein the dielectric liner comprises silicon and nitrogen.

Example 48 includes the integrated circuit of any one of Examples 32-47, wherein the subregion comprises a conductive contact structure in contact with a bottom surface of the gate structure.

Example 49 includes the integrated circuit of Example 48, wherein the conductive contact structure comprises a barrier layer and conductive fill material.

Example 50 includes the integrated circuit of any one of Examples 32-42 or 44-48, wherein the semiconductor region is a first semiconductor region, the gate structure is a first gate structure, the dielectric layer is a first dielectric layer, and the subregion is a first subregion. The integrated circuit further includes a second semiconductor region adjacent to the first semiconductor region and extending in the first direction, a second gate structure extending over the second semiconductor region in the second direction, a second dielectric layer beneath the second gate structure, and a second subregion beneath the second semiconductor region and laterally adjacent to the second dielectric layer. A top surface of the second subregion is substantially coplanar with a top surface of the dielectric layer. The first subregion is a dielectric subregion, and the second subregion includes a contact structure in contact with the second gate structure.

Example 51 is a printed circuit board comprising the integrated circuit of any one of Examples 32-50.

Example 52 is an electronic device that includes a chip package having one or more dies. At least one of the one or more dies includes a semiconductor device having a semiconductor region extending in a first direction from a source or drain region and a gate structure extending over the semiconductor region in a second direction different from the first direction, a dielectric layer beneath the gate structure, and a subregion beneath the semiconductor region and laterally adjacent to the dielectric layer. A top surface of the subregion is substantially coplanar with a top surface of the dielectric layer.

Example 53 includes the electronic device of Example 52, wherein the gate structure comprises a gate electrode and a gate dielectric, and wherein no portion of the gate dielectric is on the top surface of the subregion.

Example 54 includes the electronic device of Example 52 or 53, wherein the at least one of the one or more dies further comprises a dielectric structure extending through the gate structure in the first direction and adjacent to the semiconductor region, the dielectric structure also extending in a third direction through an entire thickness of the gate structure and along at least a portion of an entire thickness of the subregion.

Example 55 includes the electronic device of Example 54, wherein the dielectric layer is between the subregion and the dielectric structure along the second direction.

Example 56 includes the electronic device of any one of Examples 52-55, further comprising a printed circuit board, wherein the chip package is attached to the printed circuit board.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a semiconductor region extending from a source or drain region in a first direction;
a gate structure extending over the semiconductor region in a second direction different from the first direction; and
a subregion beneath the semiconductor region;
wherein no portion of the gate structure extends below a topmost surface of the subregion and at least a portion of the gate structure contacts the topmost surface of the subregion.

2. The integrated circuit of claim 1, wherein the subregion comprises a dielectric liner along edges of the subregion.

3. The integrated circuit of claim 2, wherein the subregion further comprises a dielectric fill within at least a portion of a remaining volume of the subregion and on the dielectric liner.

4. The integrated circuit of claim 3, wherein the dielectric fill comprises silicon and any one of nitrogen, carbon, or oxygen.

5. The integrated circuit of any one of claims 2 through 4, wherein the dielectric liner comprises silicon and nitrogen.

6. The integrated circuit of any one of claims 1 through 5, wherein the subregion comprises a conductive contact structure in contact with a bottom surface of the gate structure.

7. The integrated circuit of any one of claims 1 through 6, wherein the gate structure comprises a gate electrode and a gate dielectric, and wherein no portion of the gate dielectric is on the topmost surface of the subregion.

8. The integrated circuit of claim 7, wherein the gate dielectric comprises hafnium and oxygen.

9. The integrated circuit of any one of claims 1 through 8, wherein the semiconductor region comprises one or more semiconductor nanoribbons.

10. The integrated circuit of claim 9, wherein the one or more semiconductor nanoribbons comprises germanium, silicon, or any combination thereof.

11. The integrated circuit of any one of claims 1 through 10, further comprising a dielectric structure extending through the gate structure in the first direction and adjacent to the semiconductor region, the dielectric structure also extending in a third direction through an entire thickness of the gate structure and along at least a portion of an entire thickness of the subregion.

12. The integrated circuit of claim 11, further comprising a dielectric layer laterally adjacent to the subregion and between the subregion and the dielectric structure.

13. The integrated circuit of any one of claims 1 through 12, further comprising dielectric fill laterally adjacent to and contacting the subregion, wherein the dielectric fill comprises a first dielectric material, and the subregion comprises a second dielectric material that is compositionally different from the first dielectric material, and wherein the first dielectric material is etch selective with respect to the second dielectric material.

14. The integrated circuit of any one of claims 1 through 13, further comprising dielectric fill laterally adjacent to and contacting the subregion, wherein the subregion comprises a contact structure in contact with the gate structure.

15. A printed circuit board comprising the integrated circuit of any one of claims 1 through 14.
